(19) Europäisches Patentamt
European Patent Office
Office européen des brevets

(11) **EP 4 329 180 A1**

(12) **EUROPÄISCHE PATENTANMELDUNG**

(43) Veröffentlichungstag:
**28.02.2024 Patentblatt 2024/09**

(21) Anmeldenummer: **22191461.7**

(22) Anmeldetag: **22.08.2022**

(51) Internationale Patentklassifikation (IPC):
*H02M 7/483* (2007.01)   *H02M 1/32* (2007.01)
*H02P 3/22* (2006.01)   *H02H 9/04* (2006.01)

(52) Gemeinsame Patentklassifikation (CPC):
**H02M 7/4835; H02H 9/041; H02M 1/32; H02P 3/22**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Hofmann, Viktor**
**95448 Bayreuth (DE)**
• **Hofstetter, Patrick**
**91056 Erlangen (DE)**

(74) Vertreter: **Siemens Patent Attorneys**
**Postfach 22 16 34**
**80506 München (DE)**

(54) **STEUERVERFAHREN FÜR EINEN MODULAREN BREMSSTELLER**

(57) Die Erfindung betrifft ein Verfahren zum Betreiben eines modularen Bremsstellers (1), wobei der modulare Bremssteller (1) mindestens ein Submodul (2) und einen Bremswiderstand (3) umfasst, die in einer Reihenschaltung (4) angeordnet sind. Zur Verbesserung der Funktion des modularen Bremsstellers wird vorgeschlagen, dass mittels des mindestens einen Submoduls (1) eine blockförmige oder trapezförmige Spannung ($u_{BR}$) erzeugt wird. Ferner betrifft die Erfindung eine Steuereinrichtung (10), eingerichtet zur Durchführung eines derartigen Verfahrens. Die Erfindung betrifft weiter einen modularen Bremssteller (1), wobei der modulare Bremssteller (1) mindestens ein Submodul (2) und einen Bremswiderstand (3) umfasst, die in einer Reihenschaltung (4) angeordnet sind, wobei mittels des mindestens einen Submoduls (1) eine blockförmige oder trapezförmige Spannung ($u_{BR}$) erzeugbar ist, wobei zur Steuerung oder Regelung des mindestens einen Submoduls (2) der modulare Bremssteller (1) eine derartige Steuereinrichtung (10) aufweist. Die Erfindung betrifft ferner eine modulare Antriebseinheit (20), aufweisend einen modularen Multilevel-Stromrichter (21) und einen derartigen modularen Bremssteller (1), wobei der modulare Bremssteller (1) mit einer Gleichspannungsseite des modularen Multilevel-Stromrichters (21) elektrisch verbunden ist.

FIG 5

**Beschreibung**

Die Erfindung betrifft ein Verfahren zum Betreiben eines modularen Bremsstellers, wobei der modulare Bremssteller mindestens ein Submodul und einen Bremswiderstand umfasst, die in einer Reihenschaltung angeordnet sind. Weiter betrifft die Erfindung eine Steuereinrichtung, eingerichtet zur Durchführung eines derartigen Verfahrens. Ferner betrifft die Erfindung einen modularen Bremssteller, wobei der modulare Bremssteller mindestens ein Submodul und einen Bremswiderstand umfasst, die in einer Reihenschaltung angeordnet sind, wobei zur Steuerung oder Regelung des mindestens einen Submoduls der modulare Bremssteller eine derartige Steuereinrichtung aufweist. Die Erfindung betrifft ferner eine modulare Antriebseinheit, aufweisend einen modularen Multilevel-Stromrichter und einen derartigen modularen Bremssteller, wobei der modulare Bremssteller mit einer Gleichspannungsseite des modularen Stromrichters elektrisch verbunden ist.

Ein modularer Multilevel-Stromrichter ist aus der DE 10 103 031 A1 bekannt. Dieser, auch als M2C oder MMC bekannte Stromrichter, besitzt eine Konverter-Topologie, die aufgrund des Aufbaus mit Submodulen insbesondere für Mittel- und Hochspannungsanwendungen geeignet ist. Der Grundaufbau des mehrphasigen Konverters umfasst zwei Konverterarme pro Phase, die jeweils eine Reihenschaltung von Submodulen aufweisen. Dabei sind die beiden Konverterarme am Phasenanschluss miteinander verbunden. Die andere Seite der Konverterarme ist mit der Gleichspannungsseite verbunden. Die Wechselspannungsseite des modularen Multilevel-Stromrichters wird durch einen oder mehrere Phasenanschlüsse gebildet. Im grundlegenden Aufbau kann mit dem Konverter Energie zwischen der Gleichspannungsseite und der Wechselspannungsseite bidirektional übertragen oder in einem gewissen Maß zwischengespeichert werden.

Um zusätzlich einen gezielten Energieabbau zu ermöglichen, ist die Installation eines Bremsstellers zweckmäßig. Ein modularer Bremssteller ist aus der WO 2007/023061 A2 bekannt. Der modulare Bremssteller wird üblicherweise an die Gleichspannungsseite des modularen Multilevel-Stromrichters beispielsweise zwischen einem DC+ und einem DC- Anschluss angeschlossen.

Der Widerstand einer Bremsstelleranordnung wird oftmals auch als Bremswiderstand bezeichnet, da dieser dazu geeignet ist, elektrische Energie einer elektrischen Maschine, die aufgrund eines Bremsvorgangs erzeugt wird, in Wärme umzuwandeln. Dabei ist die Verwendung eines Bremsstellers nicht auf die Anwendung eines bremsenden elektrischen Antriebs beschränkt. So muss es sich nicht notwendigerweise um Bremsenergie handeln, die in Wärme umgewandelt wird. Der Bremssteller kann beispielsweise auch zur Stabilisierung eines Energieversorgungsnetzes eingesetzt werden, indem er elektrische Energie aus dem Energieversorgungsnetz in Wärme umwandelt. Der Begriff Bremswiderstand wurde gewählt, um den Widerstand, in dem eine vorgegebene elektrische Energie bzw. Leistung in Wärme bzw. Wärme pro Zeit umgesetzt wird, von anderen Widerständen unterscheiden zu können.

Mit der Bezeichnung, eine in Wärme umzusetzende Leistung ist im Folgenden gemeint, dass das Integral der Leistung über die Zeit in Wärme umgesetzt wird. Mit anderen Worten wird eine sich aus der Leistung über die Zeit ergebende Energiemenge in Wärme umgesetzt.

Der Erfindung liegt die Aufgabe zugrunde, einen modularen Bremssteller zu verbessern.

Diese Aufgabe wird durch ein Verfahren zum Betreiben eines modularen Bremsstellers gelöst, wobei der modulare Bremssteller mindestens ein Submodul und einen Bremswiderstand umfasst, die in einer Reihenschaltung angeordnet sind, wobei mittels des mindestens einen Submoduls eine blockförmige oder trapezförmige Spannung erzeugt wird. Ferner wird diese Aufgabe durch eine Steuereinrichtung gelöst, die eingerichtet ist zur Durchführung eines derartigen Verfahrens. Diese Aufgabe wird weiter durch einen modularen Bremssteller gelöst, wobei der modulare Bremssteller mindestens ein Submodul und einen Bremswiderstand umfasst, die in einer Reihenschaltung angeordnet sind, wobei mittels des mindestens einen Submoduls eine blockförmige oder trapezförmige Spannung erzeugbar ist, wobei zur Steuerung oder Regelung des mindestens einen Submoduls der modulare Bremssteller eine derartige Steuereinrichtung aufweist. Ferner wird diese Aufgabe durch eine modulare Antriebseinheit gelöst, wobei die modulare Antriebseinheit einen modularen Multilevel-Stromrichter und einen derartigen modularen Bremssteller aufweist, wobei der modulare Bremssteller mit einer Gleichspannungsseite des modularen Multilevel-Stromrichters elektrisch verbunden ist.

Weitere vorteilhafte Ausgestaltungen der Erfindung sind in den abhängigen Ansprüchen angegeben.

Der Erfindung liegt unter anderem die Erkenntnis zugrunde, dass sich durch den modularen Aufbau des modularen Bremsstellers jede Betriebsspannung des Bremsstellers realisieren lässt. Üblicherweise wird der modulare Bremssteller mit dem Zwischenkreis eines Stromrichters verbunden, um elektrische Energie aus einem Antriebssystem oder einem Energieversorgungssystem in Wärme umwandeln zu können. Mit dem modularen Aufbau lässt sich der modulare Bremssteller durch Verwendung einer entsprechenden Anzahl an Submodulen an beliebig hohe Zwischenkreisspannungen anpassen.

Als Submodule können dabei alle bereits bekannten Typen von Submodulen verwendet werden. Dazu zählen beispielsweise Halbbrückenmodule, Doppelhalbbrückenmodule oder auch Vollbrückenmodule. Zur Erzeugung von Spannungen kann allein die Kondensatorspannung oder die Kondensatorspannungen des entsprechenden Submoduls genutzt werden. Alternativ ist es auch möglich, beispielsweise durch Verwendung einer Pulsweitenmodulation auch eine Spannung durch das Submodul zu erzeugen, die kleiner ist als die Kondensatorspannung bzw. Kondensatorspannungen. Insbesondere bei der Verwendung nur eines Submoduls hat sich die Pulsweitenmodulation als vorteilhaft erwiesen, um unterschiedliche Spannungen zu erzeugen.

Darüber hinaus ermöglicht das Verfahren zum Betreiben des modularen Bremsstellers, die in Wärme umzuwandelnde Leistung genau zu steuern oder zu regeln. Die Wärme ergibt sich dann aus dem zeitlichen Integral der Leistung. Das Verfahren sieht vor, dass nicht die gesamte Zwischenkreisspannung bei der Energieumwandlung am Bremswiderstand abfällt. Der Vorteil liegt darin, die in Wärme umzuwandelnde Leistung regeln zu können. Gleichzeitig wird der Energieinhalt des Kondensators oder der Kondensatoren des mindestens einen Submoduls oder der Submodule geregelt. Damit ist ein stabiler Betrieb des modularen Bremsstellers auch über längere Betriebsdauern, insbesondere für einen kontinuierlichen Betrieb, möglich.

Der Bremswiderstand kann an beliebiger Stelle in der Reihenschaltung angeordnet sein. Beispielsweise kann der Bremswiderstand zwischen einem der Anschlüsse des modularen Bremsstellers und einem Submodul oder an beliebiger Stelle zwischen zwei Submodulen angeordnet sein.

Für den Fall, dass der modulare Bremssteller nicht aktiv ist, also keine elektrische Energie in Wärme umsetzen soll, ist die über dem mindestens einen Submodul oder der weiteren Reihenschaltung von Submodulen anliegende Spannung identisch der Zwischenkreisspannung, so dass über dem Widerstand keine Spannung abfällt und damit auch kein Strom fließt.

Für die Steuerung oder Regelung wird eine Spannung über dem mindestens einen Submodul oder, falls mehrere Submodule in einer weiteren Reihenschaltung angeordnet sind, über der weiteren Reihenschaltung der Submodule erzeugt. Für die Steuerung oder Regelung der in Wärme umzuwandelnden Leistung wird hierfür ein Gleichanteil der Spannung vorgesehen. Für die Regelung der Kondensatorspannung oder der Kondensatorspannungen des oder der Submodule wird ein alternierender Anteil dem Gleichanteil überlagert. Durch die Überlagerung von Gleichanteil und alternierendem Anteil ergibt sich ein blockförmiger Verlauf der Spannung. Der blockförmige Verlauf setzt wiederum voraus, dass sich die Spannungen über der weiteren Reihenschaltung beliebig schnell ändern lässt. Dies führt zu einer unendlichen Spannungssteilheit. Da diese Spannungen entsprechende Ströme bewirken, hat es sich als vorteilhaft erwiesen, die Änderungsgeschwindigkeit der Spannungsänderung zu beschränken. Durch den mit den Spannungsänderungen einhergehenden Strömen eignet sich der modulare Bremssteller dann auch für Bremssteller, die eine Induktivität, beispielsweise als parasitäre Induktivität des Bremswiderstands aufweisen. Aus der blockförmigen Spannung wird dann eine trapezförmige Spannung.

Es hat sich als vorteilhaft erwiesen, dass sich mit der blockförmigen bzw. trapezförmigen Spannung bei vergleichsweise geringen Amplituden von Spannung über der weiteren Reihenschaltung der Submodule und von den durch den modularen Bremssteller fließenden Strom hohe Energie austauschen lassen, da sich die Energie aus dem zeitlichen Integral des Stromes, bzw. aus dem Integral des Quadrats des Stromes ergibt. Das heißt, es kann eine hohe Leistung erreicht werden. Diese hohe Leistung bezieht sich auf die in Wärme umzuwandelnde Leistung als auch auf die zur Stabilisierung der Submodule verwendete Leitung. Mit anderen Worten sind aufgrund der relativ geringen Beträge von Strom und Spannung, insbesondere geringen Amplituden oder geringen Maximalwerten im Strom- und Spannungsverlauf, vergleichsweise hohe Effektivwerte erreichbar, die für eine Umwandlung in Wärme durch den Bremswiderstand maßgeblich sind. Aufgrund der niedrigen Amplitude bzw. niedrige Schwankungsbreite durch die Verwendung der Block- bzw. Trapezform der Spannung und den damit einhergehenden Strömen können die Halbleiterschalter der Submodule auf eine geringere Strombelastung ausgelegt werden.

Alternativ ist es möglich, den modularen Bremssteller zur Umwandlung höherer Leistungen in Wärme zu nutzen.

Die blockförmige bzw. trapezförmige Spannung kann auf einfache Weise durch eine Steuereinrichtung erzeugt werden, die die Halbleiterschalter des Submoduls oder der Submodule der weiteren Reihenschaltung ansteuert.

Besonders vorteilhaft ist es, den modularen Bremssteller mit dem modularen Multilevel-Stromrichter, auch als M2C Stromrichter bezeichnet, zu einer modularen Antriebseinheit zu kombinieren. Dabei können für den modularen Multilevel-Stromrichter als auch für den modularen Bremssteller baugleiche Submodule zum Einsatz kommen. Ebenso kann die gleiche Hardware für die Steuerung der Submodule verwendet werden. Durch den modularen Aufbau, sowohl von Stromrichter als auch vom modularen Bremssteller kann die modulare Antriebseinheit einfach an eine geforderte Leistungsanforderung durch die Wahl einer entsprechenden Anzahl von Submodulen im Stromrichter und im modularen Bremssteller angepasst werden. Durch die baugleiche Ausführung der Submodule in modularem Bremssteller und Multilevel-Stromrichter kann ein hoher Anteil an Gleichteilen erzielt werden. Dies wirkt sich positiv auf die Zuverlässigkeit und die Herstellkosten einer derartigen Antriebseinheit aus.

Der modulare Bremssteller kann an die Gleichspannungsseite von Stromrichtern mit beliebigem Aufbau angeschlossen werden und ist nicht auf die Anwendung mit einem modularen Multilevel-Stromrichter beschränkt.

Bei einer vorteilhaften Ausgestaltung der Erfindung umfasst der modulare Bremssteller eine Vielzahl von Submodulen, die in einer weiteren Reihenschaltung angeordnet sind, wobei mittels der Vielzahl von Submodulen die blockförmige oder trapezförmige Spannung über der weiteren Reihenschaltung der Submodule erzeugt wird. Durch die Verwendung einer Vielzahl von Submodulen in der weiteren Reihenschaltung kann die Betriebsspannung des modularen Bremsstellers beliebig an die Zwischenkreisspannung des Stromrichters angepasst werden. Dabei sind beliebig hohe Betriebsspannungen, also Zwischenkreisspannungen in der Antriebseinheit, realisierbar.

Bei einer weiteren vorteilhaften Ausgestaltung der Erfindung weist die blockförmige bzw. trapezförmige Spannung einen Gleichanteil auf, wobei der Gleichanteil in Abhängigkeit von der mittels des modularen Bremsstellers in Wärme umzuwandelnden Leistung oder in Abhängigkeit von der über der am modularen Bremssteller anliegenden Spannung gesteuert oder geregelt wird. Mit dem Gleichanteil der Spannung kann ein Strom durch den modularen Bremssteller erzeugt werden, der auch einen weiteren Gleichanteil aufweist. Dieser Gleichanteil fließt durch den modularen Bremssteller und somit auch den Bremswiderstand. Dabei erzeugt der durch den Bremswiderstand fließende Strom elektrische Verluste. Diese werden genutzt, um gezielt elektrische Energie in Wärme umzuwandeln. Die Höhe der in Wärme umzusetzenden Leistung, also Energie pro Zeiteinheit, kann durch die Höhe des Gleichanteils der Spannung gesteuert oder geregelt werden, da sich damit direkt die über dem Widerstand abfallende Spannung und daraus wiederum der weitere Gleichanteil des Stroms durch den modularen Bremssteller ergibt. Somit hat es sich als vorteilhaft erwiesen, den Gleichanteil in Abhängigkeit von der in Wärme umzuwandelnden Leistung zu steuern oder zu regeln. Dabei kann diese Leistung wieder von anderen Größen abhängen wie beispielsweise der Spannung des Kondensators der Submodule eines modularen Multilevel-Stromrichters. Falls der modulare Bremssteller an einem Zwischenkreis mit Zwischenkreiskondensator betrieben wird, beispielsweise an einem 2-Punkt- oder 3-Punkt-Stromrichter, hat es sich als vorteilhaft erwiesen, den Gleichanteil in Abhängigkeit von der Zwischenkreisspannung zu steuern oder zu regeln. Mit diesen Regelungsstrukturen lassen sich dynamische Regelungen zur Umwandlung von elektrischer Leistung in Wärme realisieren, die die elektrische Antriebseinheit vor Überlastung durch zu hohe Energiemengen schützen. Diese Energiemengen können sich beispielsweise aus dem Bremsvorgang einer elektrischen Maschine ergeben.

Bei einer weiteren vorteilhaften Ausgestaltung der Erfindung wird der Gleichanteil derart gesteuert oder geregelt, einen Strom mit einem weiteren Gleichanteil durch den modularen Bremssteller zu erzeugen, wobei das Produkt aus dem weiteren Gleichanteil und der Spannung über dem modularen Bremssteller einer vorgegebenen, durch den modularen Bremssteller in Wärme umzuwandelnden Leistung, insbesondere einer vorgegebenen, durch den modularen Bremssteller in Wärme umzuwandelnden Wirkleistung, entspricht. Der Gleichanteil der Spannung wird dabei in der Spannungshöhe so gesteuert oder geregelt, dass der weitere Gleichanteil des Stroms so groß ist, dass das Produkt aus der Zwischenkreisspannung und dem weiteren Gleichanteil dem Wert, der durch den modularen Bremssteller in Wärme umzuwandelnden Leistung entspricht. Bei der in Wärme umzuwandelnden Leistung handelt es sich um eine Energie, die in einer bestimmten Zeit in Wärme umgewandelt wird. Die Zwischenkreisspannung liegt über dem modularen Bremssteller an, da dieser mit dem Zwischenkreis elektrisch verbunden ist. Damit liegt die Zwischenkreisspannung über der Reihenschaltung aus Bremswiderstand und der weiteren Reihenschaltung der Submodule an. Anstelle der weiteren Reihenschaltung von Submodulen kann alternativ auch nur ein Submodul vorhanden sein. Somit nimmt der modulare Bremssteller, an dem die Zwischenkreisspannung anliegt, die Wirkleistung

$$P_{BR} = U_D \cdot i_{BR,DC} \qquad\qquad (1)$$

auf. Die gesamte vom Bremswiderstand aufgenommene Wirkleistung soll in Wärme umgesetzt werden, da der modulare Bremssteller nicht zur Aufnahme und Speicherung nennenswerter Energiebeträge ausgestaltet sein soll. Die Differenz in der Spannung zwischen der Blockform bzw. Trapezform kann beispielsweise mit einem PI Regler geregelt werden, so dass sich in den Submodulen an dem Kondensator oder den Kondensatoren eine vorgebbare Spannung einstellt. Mit anderen Worten kann eine weitere Spannungskomponente zur Erreichung der blockförmigen oder trapezförmigen Spannung in Abhängigkeit von der Spannung an dem Kondensator oder den Kondensatoren der Submodule erzeugt werden, welche beispielsweise mit Hilfe eines PI Reglers die Spannung an den Kondensatoren der Submodule regelt oder steuert. Alternativ oder ergänzend ist es auch möglich, mit Hilfe der Spannungssteilheit der Trapezform und/ oder mit der Frequenz der Trapez- oder Blockform die Spannung an den Kondensatoren der Submodule zu beeinflussen.

Bei einer weiteren vorteilhaften Ausgestaltung der Erfindung weist die blockförmige bzw. trapezförmige Spannung einen alternierenden Anteil auf, der derart bemessen ist, dass die im zeitlichen Mittel vom modularen Bremssteller aufgenommene elektrische Energie im Bremswiderstand in Wärme umgesetzt wird. Der alternierende Anteil kann dazu genutzt werden, die Kondensatorspannungen der Submodule zu beeinflussen und den modularen Bremssteller zu stabilisieren. Der alternierende Anteil der Spannung bewirkt mittels eines entsprechenden Spannungsabfalls über dem Bremswiderstand einen weiteren alternierenden Anteil im Strom durch den modularen Bremssteller. Dabei hat sowohl der alternierende Anteil als auch der weitere alternierende Anteil einen Mittelwert von null, so dass mit dem weiteren alternierenden Anteil des Stroms und der Zwischenkreisspannung bzw. der Spannung über dem modularen Bremssteller nur Blindleistung ausgetauscht wird. Es hat sich in vorteilhafter Weise gezeigt, dass dieser Anteil dazu genutzt werden kann, Energie zwischen den Kondensatoren der Submodule und dem Widerstand auszutauschen. Dabei wird der Energieaustausch in vorteilhafter Weise so gesteuert oder geregelt, dass die gesamte Wirkleistung über dem Widerstand in Wärme umgesetzt wird. Dabei wird die im zeitlichen Mittel vom modularen Bremssteller aufgenommene elektrische Energie im Bremswiderstand in Wärme umgesetzt. Als Gleichung formuliert ergibt sich dabei der Zusammenhang

$$P_{BR} = U_D \cdot i_{BR,DC} = R \cdot i_{BR,eff}^2 \qquad (2),$$

wobei der Strom $i_{BR}$ durch den Bremswiderstand sich aus dem Gleichanteil $i_{BR,DC}$ und dem alternierenden Anteil $i_{BR,aDC}$ gemäß

$$i_{BR} = i_{BR,DC} + i_{BR,aDC} \qquad (3)$$

zusammensetzt. Setzt man die Gleichung (3) in Gleichung (2) ein, so kann die entstehende Gleichung nach $i_{BR,aDC}$ aufgelöst werden. Dabei kann die blockförmige oder trapezförmige Spannungsform berücksichtigt werden. Für den einfachen und idealisierten Fall einer blockförmigen Spannungs- und Stromform ergibt sich der alternierende Anteil des Stroms zu

$$\left| i_{BR,aDC} \right| = \sqrt{\left( \frac{U_D}{R} - i_{BR,DC} \right) \cdot i_{BR,DC}} \qquad (4).$$

Damit der Mittelwert über der Zeit des Stroms $i_{BR,aDC}$ gleich null ist, ist über die Hälfte der Zeit der alternierende Anteil die Komponente mit dem Wert nach Gleichung (4) und die andere Hälfte der entsprechende Wert mit negativem Vorzeichen. Der Widerstand R muss entsprechend klein gewählt werden, damit die Formel (4) einen positiven Wert liefert.

Um diesen Strom erzeugen zu können beträgt der alternierende Anteil der Spannung über der weiteren Reihenschaltung der Submodule den Wert

$$\left| u_{BR,aDC} \right| = R \cdot \left| i_{BR,aDC} \right| = R \cdot \hat{i}_{BR,aDC} \qquad (5).$$

Damit es sich auch bei dieser Spannung um einen alternierenden Teil mit einem zeitlichen Mittelwert von null handelt, wird der oben berechnete Wert für die Hälfte der Zeit als alternierender Anteil angesetzt und für die restliche Hälfte der entsprechend negative Wert.

Bei einer weiteren vorteilhaften Ausgestaltung der Erfindung wird der alternierende Anteil als Stellgröße einer Regelung der Kondensatorspannungen der Submodule verwendet. Um Störungen ausregeln zu können, hat es sich als positiv erwiesen, die nach den Formeln ermittelten Werte des alternierenden Anteils für eine Vorsteuerung zu verwenden. Die Spannung an den Kondensatoren wird dann mittels einer Regelung geregelt. Damit kann der modulare Bremssteller auch bei Vorliegen von Störgrößen stabil betrieben werden. Des Weiteren ist der Betrieb unabhängig von sich ändernden Größen. Beispielsweise eine durch Alterung oder Erwärmung hervorgerufene Änderung des Widerstandswertes kann durch die Regelung problemlos ausgeglichen werden.

Bei einer weiteren vorteilhaften Ausgestaltung der Erfindung ist eine Wechselspannungsseite des modularen Multilevel-Stromrichters mit einer Energiequelle, insbesondere mit einem Energieversorgungsnetz oder mit einer elektrischen Maschine, verbunden. Der modulare Bremssteller kann durch die Verbindung mit einer Energiequelle dazu genutzt werden, überschüssige oder nicht nutzbare Energie in Wärme umzuwandeln. Bei der Energiequelle kann es sich beispielsweise um eine elektrische Maschine handeln, die bei einem Abbremsvorgang elektrische Energie zurückspeist. Wenn diese nicht weiter genutzt werden kann, muss diese mittels des modularen Bremsstellers in Wärme umgewandelt werden, wenn auf eine mechanische Bremse verzichtet werden soll. Die Umwandlung der elektrischen Energie in Wärme erfolgt im Gegensatz zu einer mechanischen Bremse verschleißfrei, so dass der Einsatz des modularen Bremsstellers im Betrieb wirtschaftlicher ist.

Ebenso ist es möglich, den modularen Multilevel-Stromrichter für die Energieübertragung zu nutzen. In diesem Fall kann es sinnvoll sein, für den Fall, dass die übertragene Energie nicht abgenommen werden kann, einen modularen Bremssteller vorzusehen. Dieser gewährleistet, dass eine derartige Energieübertragung auch dann im Betrieb bleibt, wenn die Entgegennahme von Energie gestört ist. Das Energieübertragungssystem kann während dieser Störung im Betrieb bleiben und ein aufwendiges neues Abschalten und Anfahren, das auch zu Stabilitätsproblemen im Energieversorgungsnetz führen kann, zuverlässig vermeiden. Somit steigert der modulare Bremssteller auch die Zuverlässigkeit und Verfügbarkeit einer modularen Antriebseinheit, die für die Energieübertragung vorgesehen ist.

Bei einer weiteren vorteilhaften Ausgestaltung der Erfindung ist die Steuereinrichtung der modularen Antriebseinheit dazu eingerichtet, die in Wärme umzuwandelnde Leistung in Abhängigkeit von der Spannung des Kondensators der Submodule des modularen Multilevel-Stromrichters zu ermitteln. Bei einem modularen Multilevel-Stromrichter zeigt sich eine im Stromrichter gespeicherte Energie nicht zwangsweise wie beispielsweise bei einem 2-Punkt- oder 3-Punkt Stromrichter an der Zwischenkreisspannung. Bei dem modularen Multilevel-Stromrichter wirkt sich ein erhöhter Energieinhalt auf die gespeicherte Energie, also die Spannung, des Kondensators oder der Kondensatoren in den jeweiligen Submodulen des modularen Multilevel-Stromrichters aus. Um den Energieinhalt im modularen Multilevel-Stromrichter gezielt zu reduzieren, hat es sich als vorteilhaft erwiesen, die für die Steuerung oder Regelung des Gleichanteils in Wärme umzusetzende Leistung in Abhängigkeit von der Spannung des Kondensators der jeweiligen Submodule des modularen Multilevel-Stromrichters zu ermitteln. Ein mögliches Verfahren zum Betreiben einer elektrischen Antriebseinheit mit einem modularen Stromrichter und einem vorgeschlagenen modularen Bremssteller regelt oder steuert den Gleichanteil der Spannung über der weiteren Reihenschaltung der Submodule des modularen Bremsstellers in Abhängigkeit von der Spannung des Kondensators oder der Kondensatoren der Submodule des modularen Multilevel-Stromrichters.

Im Folgenden wird die Erfindung anhand der in den Figuren dargestellten Ausführungsbeispiele näher beschreiben und erläutert. Es zeigen:

| FIG 1 | einen modularen Bremssteller, |
|---|---|
| FIG 2 bis FIG 4 | Ausführungsbeispiele für das Submodul, |
| FIG 5 bis FIG 8 | Zeitverläufe von Spannung und Strom und |
| FIG 9 bis FIG 11 | Ausführungsbeispiele der modularen Antriebseinheit. |

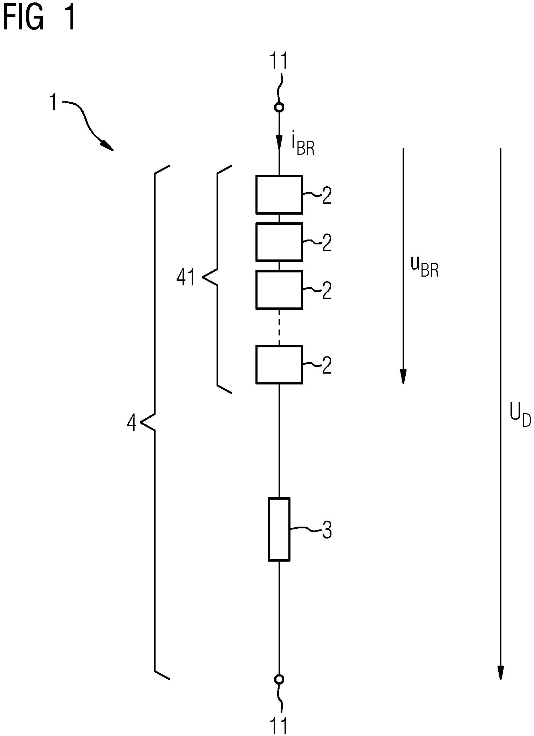

Die FIG 1 zeigt einen modularen Bremssteller 1. Dieser weist eine Reihenschaltung 4 von mindestens einem Submodul 2 und einem Bremswiderstand 3 auf. Die Reihenschaltung 4 kann eine Vielzahl von Submodulen 2 aufweisen. Diese sind wiederum als Teil der Reihenschaltung 4 in einer weiteren Reihenschaltung 41 angeordnet. Der modulare Bremssteller 1 ist dazu eingerichtet, an seinen Anschlüssen 11 mit einem Zwischenkreis 9 eines Stromrichters verbunden zu werden.

Über der weiteren Reihenschaltung 41 der Submodule lässt sich mit Hilfe einer Steuereinrichtung 10 eine Spannung $u_{BR}$ erzeugen. Mit der Spannung $u_{BR}$ lässt sich ein Strom $i_{BR}$ durch den modularen Bremssteller 1 bewirken. Der Strom $i_{BR}$ fließt auch durch den Bremswiderstand 3 und bewirkt die Umwandlung von elektrischer Energie in Wärme. Über dem modularen Bremssteller 1 liegt die Betriebsspannung $U_D$ an. Wird der modulare Bremssteller 1 mit dem Zwischenkreis eines Stromrichters verbunden, so liegt an dem modularen Bremssteller die Zwischenkreisspannung an. In diesem Fall spricht man davon, dass der modulare Bremssteller 1 mit der Gleichspannungsseite des Stromrichters verbunden ist.

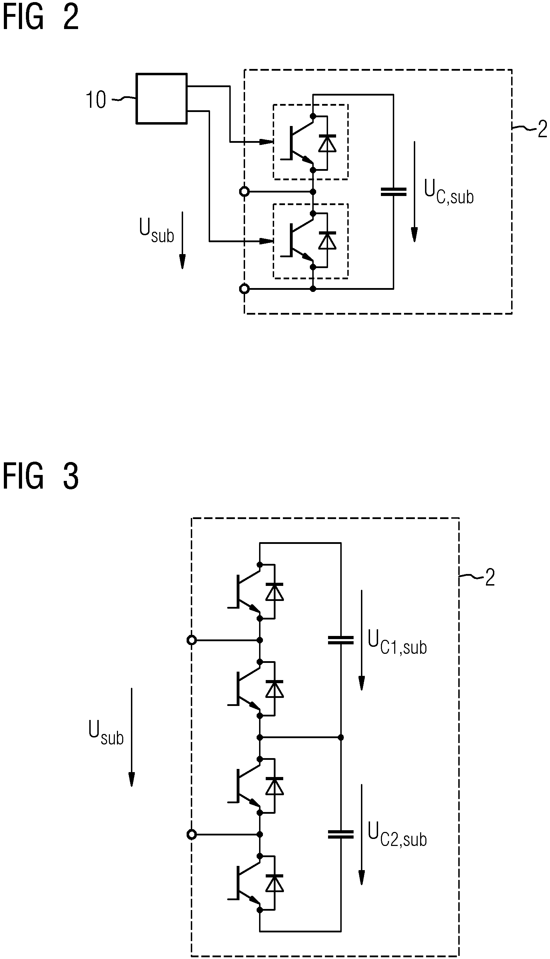

Die Figuren 2 bis 4 zeigen Ausführungsbeispiele von Submodulen 2. Alle bekannten Submodule, insbesondere die Submodule der Figuren 2 bis 4 sind für die Durchführung des vorgeschlagenen Verfahrens geeignet. Zur Vermeidung von Wiederholungen wird auf die Beschreibung zur FIG 1 und die dort eingeführten Bezugszeichen verwiesen.

Die dargestellten Ausführungsbeispiele der Submodule 2 umfassen mindestens zwei Halbleiterschalter und mindestens einen Kondensator. Durch Schalthandlungen der Halbleiterschalter kann eine Ausgangsspannung $U_{sub}$ an den Anschlüssen des Submoduls 2 erzeugt werden. Dabei übermittelt eine Steuereinrichtung 10 die Ansteuersignale an die Halbleiterschalter des Submoduls 2. Die Steuereinrichtung 10 ist vorzugsweise außerhalb des Submoduls 2 angeordnet und somit nicht Teil des Submoduls. Vielmehr hat es sich als vorteilhaft erwiesen, mit einer Steuereinrichtung 10 alle Submodule 2 des modularen Bremsstellers 1 anzusteuern. Darüber hinaus kann die Steuereinrichtung 10 die für die Steuerung und Regelung der Spannungen und Ströme erforderlichen Berechnungen vornehmen. So kann die Steuereirichtung 10 aus dem vorgegebenen Wert der in Wärme umzuwandelnden Leistung den erforderlichen Strom durch den modularen Bremssteller $i_{BR}$ bestimmen. Um diesen Strom $i_{BR}$ zu erzeugen, wird durch entsprechende Ansteuersignale eine durch die Steuereinrichtung 10 ermittelte, gesteuerte oder geregelte Spannung über den Submodulen der weiteren Reihenschaltung 41 erzeugt. In den folgenden Ausführungsbeispielen wurde auf die Darstellung der Steuereinrichtung 10 aus Gründen der Übersichtlichkeit verzichtet.

Die FIG 2 zeigt ein sogenanntes Halbbrückenmodul. Dies weist zwei Halbleiterschalter und einen Kondensator auf. An dem Kondensator liegt die Spannung $U_{C,sub}$ an. Durch Schalthandlungen der Halbleiterschalter kann die Ausgangsspannung $U_{sub}$ von null oder $U_{C,sub}$ an den Anschlüssen des Submoduls 2 erzeugt werden.

Die FIG 3 zeigt ein sogenanntes Doppelbrückenmodul. Dies weist vier Halbleiterschalter und zwei Kondensatoren auf. An den Kondensatoren liegt jeweils die Spannung $U_{C1,sub}$ bzw. $U_{C2,sub}$ an. Durch Schalthandlungen der Halbleiterschalter kann die Ausgangsspannung $U_{sub}$ von null, einer der Kondensatorspannungen $U_{C1,sub}$, $U_{C2,sub}$ oder der Summe der Kondensatorspannungen $U_{C1,sub}$, $U_{C2,sub}$ an den Anschlüssen des Submoduls 2 erzeugt werden.

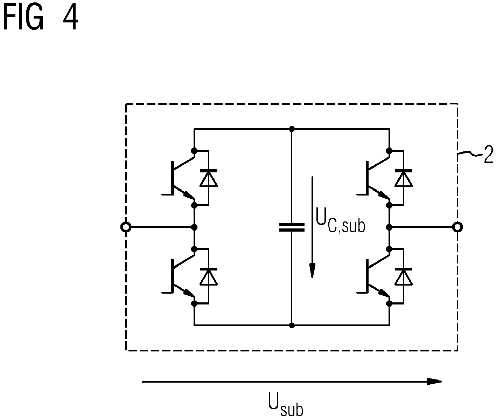

Die FIG 4 zeigt ein sogenanntes Vollbrückenmodul. Dies weist vier Halbleiterschalter und einen Kondensator auf. An dem Kondensator liegt die Spannung $U_{C,sub}$ an. Durch Schalthandlungen der Halbleiterschalter kann die Ausgangsspannung $U_{sub}$ von null, der positiven oder der negativen Kondensatorspannung $\pm U_{C,sub}$ an den Anschlüssen des Submoduls 2 erzeugt werden.

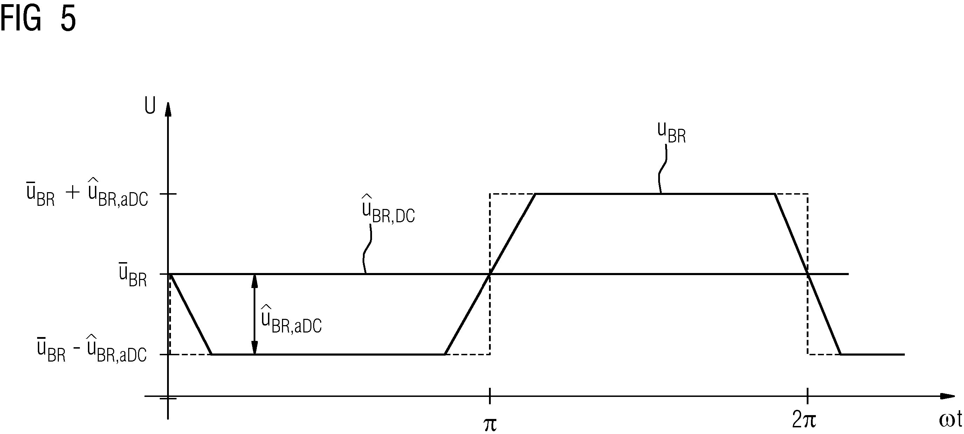

Die FIG 5 zeigt den zeitlichen Verlauf der Spannung $u_{BR}$ über den Submodulen 2 der weiteren Reihenschaltung 41 für das vorgeschlagene Verfahren. Zur Vermeidung von Wiederholungen wird auf die Beschreibung zu den Figuren 1 bis 4, sowie auf die dort eingeführten Bezugszeichen verwiesen. Die Spannung $u_{BR}$ setzt sich aus einem Gleichanteil $u_{BR,DC}$ und einem alternierenden Anteil $u_{BR,aDC}$ zusammen, wobei sich der alternierende Anteil um den Wert $+\hat{u}_{BR,aDc}$ und $-\hat{u}_{BR,aDc}$ für jeweils eine halbe Schaltperiode annimmt. Damit hat der alternierende Anteil $u_{BR,aDC}$ keinen Gleichanteil, ist also mittelwertfrei. Durch die Überlagerung von Gleichanteil $u_{BR,DC}$ und alternierendem Anteil $u_{BR,aDC}$ ergibt sich die Spannung $u_{BR}$. Aufgrund einer endlichen Spannungssteilheit des alternierenden Anteils, der seinen Wert in Form einer Rampe ändert, ergibt sich ein trapezförmiger Spannungsverlauf für die Spannung $u_{BR}$. Setzt man eine hohe, im Idealfall unendliche, Flankensteilheit an, so ergibt sich der gestrichelt dargestellte Verlauf im Übergang und daraus eine blockförmige Spannungsform der Spannung $u_{BR}$.

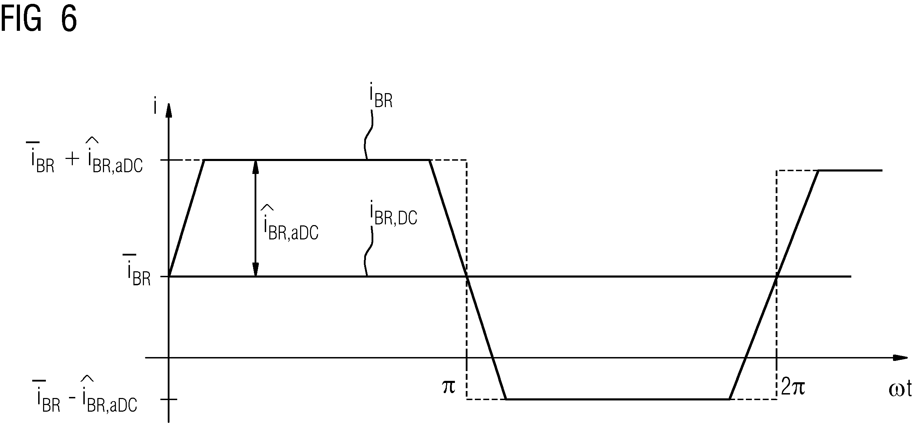

Die FIG 6 zeigt beispielhaft den sich aus dem Spannungsverlauf der FIG 5 ergebenen Stromverlauf $i_{BR}$ durch den modularen Bremssteller 1. Durch die Spannung $u_{BR}$ ergibt sich eine Spannung über den Bremswiderstand 3, der einen Strom $i_{BR}$ mit einem weiteren Gleichanteil $i_{BR,DC}$ und einem weiteren alternierenden Anteil $i_{BR,aDC}$ bewirkt. Zur Unterscheidung vom Gleichanteil bzw. alternierenden Anteil der Spannung wird dieser Gleichanteil bzw. alternierender Anteil des Stroms als weiterer Gleichanteil bzw. weiterer alternierender Anteil bezeichnet.

In der Zeit, in der die Spannung über den Submodulen 2 in der weiteren Reihenschaltung 41 klein ist, fällt eine größere Spannung über dem Bremswiderstand 4 ab, so dass auch ein größerer Strom $i_{BR}$ durch den modularen Bremssteller 1 entsteht und umgekehrt. Dabei kann der Strom $i_{BR}$ durch den Bremswiderstand 3 in Abhängigkeit der Höhe des alternierenden Anteils $u_{BR,aDC}$ zeitweise negativ werden. Mit anderen Worten kann je nach Arbeitspunkt der Betrag des alternierenden Anteils größer werden als der Gleichanteil. Bei der Verwendung von unipolaren Submodulen, die nur eine Polarität in ihrer Ausgangsspannung $U_{sub}$ annehmen können wie beispielsweise Halbbrücken oder Doppelhalbbrücken, nimmt der Strom $i_{BR}$ durch den modularen Bremssteller 1 im Minimum einen negativen Wert an.

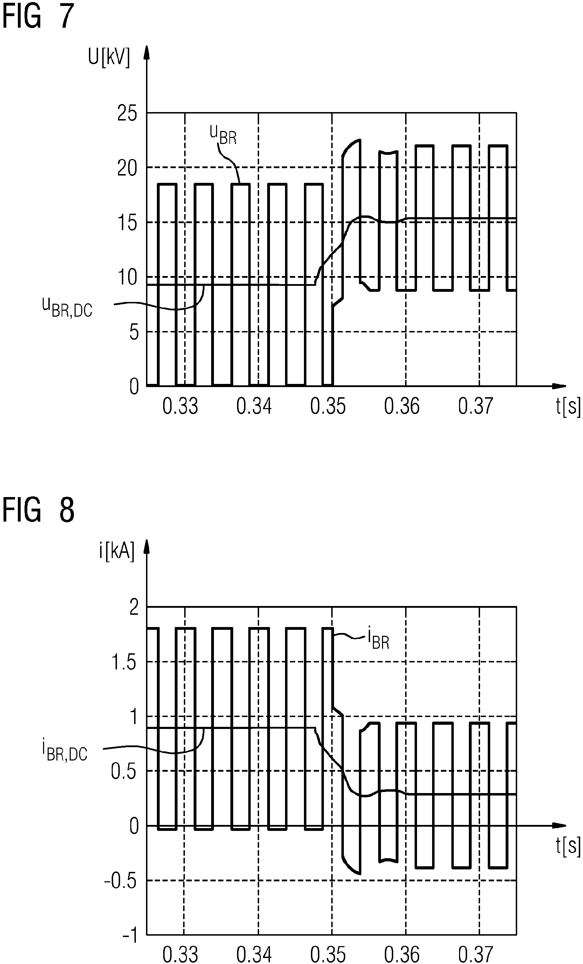

Die FIG 7 zeigt den Verlauf der Spannung $u_{BR}$ an der weiteren Reihenschaltung 41 der Submodule 2 des modularen Bremsstellers 1 für eine Anwendung im Mittelspannungsbereich. Der Mittelspannungsbereich beginnt ab einer Spannung von 1000 V, auch mit 1 kV bezeichnet. Dem dargestellten Gleichanteil $u_{BR,DC}$ ist ein alternierender Anteil $u_{BR,aDC}$ derart überlagert, dass sich der Spannungsverlauf der Spannung $u_{BR}$ ergibt. Dabei ändert sich zwischen den Zeitpunkten t=0,34s und t=0,36s der Wert der in Wärme umzuwandelnden Leistung. In dem dargestellten Verlauf wird diese Leistung reduziert. Dieser Wert wird dem modularen Bremssteller 1 bzw. seiner Steuereinrichtung 10 vorgegeben. Beispielsweise kann dieser Wert sich aus der Spannung des Zwischenkreises $U_D$ ergeben, an dem der modulare Bremssteller angeschlossen ist oder die, allgemein formuliert, an den Anschlüssen 11 des modularen Bremsstellers 1 anliegt. Ebenso kann der Wert auch in Abhängigkeit der Spannung an dem Kondensator oder den Kondensatoren der Submodule eines mit dem modularen Bremssteller 1 verbundenen modularen Multilevel-Stromrichters ermittelt werden. Der modulare Bremssteller 1 mit der Steuereinrichtung 10 reagiert darauf, dass er den Gleichanteil $u_{BR,DC}$ erhöht. Gleichzeitig erkennt man an der geringeren Schwankungsbreite der Spannung $u_{BR}$ einen geringeren alternierenden Anteil $u_{BR,aDC}$. Dieser alternierende Anteil $u_{BR,aDC}$ stabilisiert die Kondensatorspannungen $U_C$ der Kondensatoren der Submodule 2.

Die FIG 8 zeigt den dazugehörigen Verlauf des Stroms $i_{BR}$ durch den modularen Bremssteller mit seinem weiteren Gleichanteil $i_{BR,DC}$. Die Reduktion der Leistung ist an dem kleineren Strom erkennbar. Darüber hinaus liegt ab dem Zeitpunkt t=0,35s ein Arbeitspunkt vor, bei dem der Strom $i_{BR}$ zeitweise einen deutlich negativen Wert annimmt. Zu den Zeitpunkten vor t=0,35s ist der Strom beim Minimum nur kaum erkennbar negativ.

Die Zeitverläufe der FIG 7 und FIG 8 weisen derart hohe Änderungsgeschwindigkeiten auf, dass die Zeitverläufe als blockförmige Zeitverläufe beschrieben werden können.

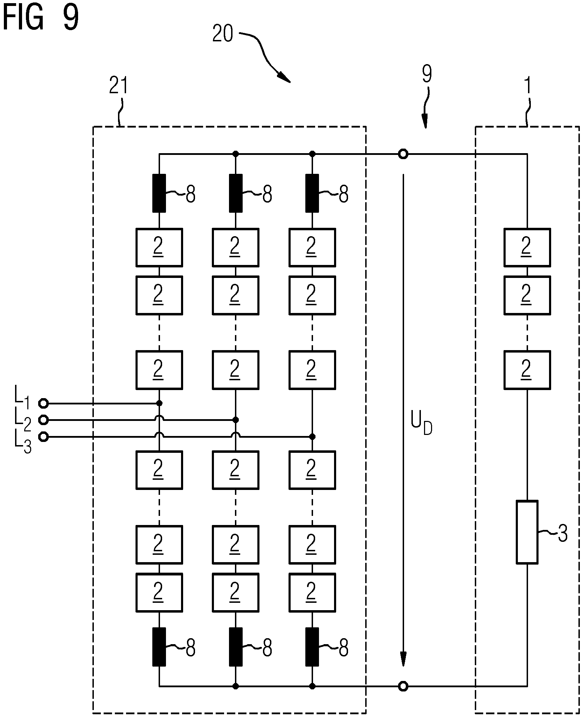

Die FIG 9 zeigt eine modulare Antriebseinheit 20 mit einem modularen Multilevel-Stromrichter 21 und einem modularen Bremssteller 1. Diese sind über den Zwischenkreis 9, an dem die Spannung $U_D$ anliegt, miteinander verbunden. Dabei kann, nicht notwendigerweise, der modulare Multilevel-Stromrichter 21 die gleichen Submodule 2 aufweisen wie der modulare Bremssteller 1. Die Reihenschaltung der Submodule 2 des modularen Multilevel-Stromrichters 21 weist darüber hinaus noch eine Induktivität 8 auf, die das Regelverhalten des modularen Multilevel-Stromrichters 21 verbessert. Die Anschlüsse L1, L2, L3 stellen die wechselspannungsseitigen Anschlüsse oder kurz die Wechselspannungsseite des modularen Multilevel-Stromrichters 21 dar. In diesem Ausführungsbeispiel ist der modulare Multilevel-Stromrichter 21 dreiphasig ausgeführt. Alternativ ist auch eine einphasige Ausführung mit Neutralleiter oder auch jede beliebige Phasenanzahl möglich, indem entsprechend viele Phasenmodule im modularen Multilevel-Stromrichter 21 vorgesehen werden.

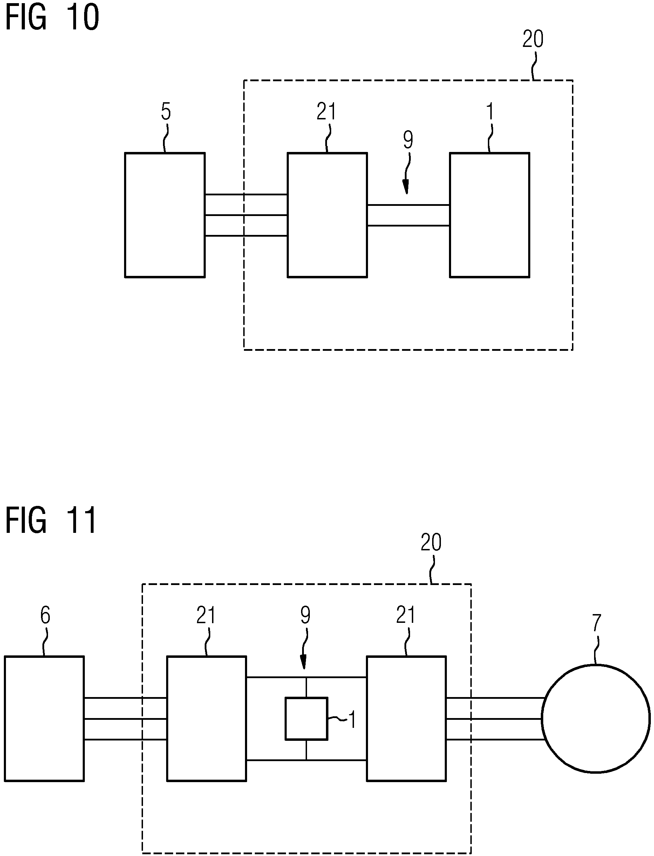

In der FIG 10 ist ein Ausführungsbeispiel einer modularen Antriebseinheit 20 dargestellt. Dabei ist eine Energiequelle 5 mit der Wechselspannungsseite des modularen Multilevel-Stromrichters 21 elektrisch verbunden. Bei der Energiequelle kann es sich beispielsweise um ein Energieversorgungsnetz 6 oder eine elektrische Maschine 7 handeln.

Im Ausführungsbeispiel der FIG 11 weist die modulare Antriebseinheit 20 zwei modulare Multilevel-Stromrichter 21 und einen modularen Bremssteller 1 auf, die am Zwischenkreis 9 miteinander elektrisch verbunden sind. Dabei ist ein erster der zwei modularen Multilevel-Stromrichter 21 an seiner Wechselspannungsseite mit einem Energieversorgungsnetz 6 und ein zweiter der zwei modularen Multilevel-Stromrichter 21 an seiner Wechselspannungsseite mit einer elektrischen Maschine 7 verbunden. Die elektrische Maschine 7 kann dabei aus dem Energieversorgungsnetz 6 mit elektrischer Energie versorgt werden. Auch eine Rückspeisung von Energie von der elektrischen Maschine 7 in das Energieversorgungsnetz 6 beispielsweise bei einem Bremsvorgang ist mit der modularen Antriebseinheit 20 möglich. Falls das Energieversorgungsnetz 6 nicht aufnahmefähig ist, kann die durch die elektrische Maschine 7 gewonnene elektrische Energie mittels des modularen Bremsstellers 1 in vorteilhafter Weise in Wärme umgewandelt werden. Auf eine verschleißbehaftete mechanische Bremse kann in dieser Ausgestaltung verzichtet werden.

Zusammenfassend betrifft die Erfindung ein Verfahren zum Betreiben eines modularen Bremsstellers 1, wobei der modulare Bremssteller 1 mindestens ein Submodul 2 und einen Bremswiderstand 3 umfasst, die in einer Reihenschaltung 4 angeordnet sind. Zur Verbesserung der Funktion des modularen Bremsstellers wird vorgeschlagen, dass mittels des mindestens einen Submoduls 1 eine blockförmige oder trapezförmige Spannung $u_{BR}$ erzeugt wird. Ferner betrifft die Erfindung eine Steuereinrichtung 10, eingerichtet zur Durchführung eines derartigen Verfahrens. Die Erfindung betrifft weiter einen modularen Bremssteller 1, wobei der modulare Bremssteller 1 mindestens ein Submodul 2 und einen Bremswiderstand 3 umfasst, die in einer Reihenschaltung 4 angeordnet sind, wobei mittels des mindestens einen Submoduls 1 eine blockförmige oder trapezförmige Spannung $u_{BR}$ erzeugbar ist, wobei zur Steuerung oder Regelung des mindestens einen Submoduls 2 der modulare Bremssteller 1 eine derartige Steuereinrichtung 10 aufweist. Die Erfindung betrifft ferner eine modulare Antriebseinheit 20, aufweisend einen modularen Multilevel-Stromrichter 21 und einen derartigen modularen Bremssteller 1, wobei der modulare Bremssteller 1 mit einer Gleichspannungsseite des modularen Multilevel-Stromrichters 21 elektrisch verbunden ist.

**Patentansprüche**

1. Verfahren zum Betreiben eines modularen Bremsstellers (1), wobei der modulare Bremssteller (1) mindestens ein Submodul (2) und einen Bremswiderstand (3) umfasst, die in einer Reihenschaltung (4) angeordnet sind, wobei mittels des mindestens einen Submoduls (1) eine blockförmige oder trapezförmige Spannung ($u_{BR}$) erzeugt wird.

2. Verfahren nach Anspruch 1, wobei der modulare Bremssteller (1) eine Vielzahl von Submodulen (2) umfasst, die in einer weiteren Reihenschaltung (41) angeordnet sind, wobei mittels der Vielzahl von Submodulen (2) die blockförmige oder trapezförmige Spannung ($u_{BR}$) über der weiteren Reihenschaltung (41) der Submodule (2) erzeugt wird.

3. Verfahren nach einem der Ansprüche 1 oder 2, wobei die blockförmige bzw. trapezförmige Spannung ($u_{BR}$) einen Gleichanteil ($u_{BR,DC}$) aufweist, wobei der Gleichanteil ($u_{BR,DC}$) in Abhängigkeit von der mittels des modularen Bremsstellers (1) in Wärme umzuwandelnden Leistung oder in Abhängigkeit von der über der am modularen Bremssteller (1) anliegenden Spannung ($U_D$) gesteuert oder geregelt wird.

4. Verfahren nach Anspruch 3, wobei der Gleichanteil ($u_{BR,DC}$) derart gesteuert oder geregelt wird, einen Strom ($i_{BR}$) mit einem weiteren Gleichanteil ($i_{BR,DC}$) durch den modularen Bremssteller (1) zu erzeugen, wobei das Produkt aus dem weiteren Gleichanteil ($i_{BR,DC}$) und der Spannung ($U_D$) über dem modularen Bremssteller (1) einer vorgegebenen, durch den modularen Bremssteller (1) in Wärme umzuwandelnden Leistung, insbesondere einer vorgegebenen, durch den modularen Bremssteller (1) in Wärme umzuwandelnden Wirkleistung, entspricht.

5. Verfahren nach einem der Ansprüche 1 bis 4, wobei die blockförmige bzw. trapezförmige Spannung ($u_{BR}$) einen alternierenden Anteil ($u_{BR,aDC}$) aufweist, der derart bemessen ist, dass die im zeitlichen Mittel vom modularen Bremssteller (1) aufgenommene elektrische Energie im Bremswiderstand (3) in Wärme umgesetzt wird.

6. Verfahren nach Anspruch 5, wobei der alternierende Anteil ($u_{BR,aDC}$) als Stellgröße einer Regelung der Kondensatorspannungen ($U_{C,sub}$) der Submodule (2) verwendet wird.

7. Steuereinrichtung (10), eingerichtet zur Durchführung eines Verfahrens nach einem der Ansprüche 1 bis 6.

8. Modularer Bremssteller (1), wobei der modulare Bremssteller (1) mindestens ein Submodul (2) und einen Bremswiderstand (3) umfasst, die in einer Reihenschaltung (4) angeordnet sind, wobei mittels des mindestens einen Submoduls (1) eine blockförmige oder trapezförmige Spannung ($u_{BR}$) erzeugbar ist, wobei zur Steuerung oder Regelung des mindestens einen Submoduls (2) der modulare Bremssteller (1) eine Steuereinrichtung (10) nach Anspruch 7 aufweist.

9. Modularer Bremssteller (1) nach Anspruch 8, wobei der modulare Bremssteller (1) eine Vielzahl von Submodulen (2) umfasst, die in einer weiteren Reihenschaltung (41) angeordnet sind, wobei mittels der Vielzahl von Submodulen (2) eine blockförmige oder trapezförmige Spannung ($u_{BR}$) über der weiteren Reihenschaltung (41) erzeugbar ist.

10. Modulare Antriebseinheit (20), aufweisend einen modularen Multilevel-Stromrichter (21) und einen modularen Bremssteller (1) nach einem der Ansprüche 8 oder 9, wobei der modulare Bremssteller (1) mit einer Gleichspannungsseite des modularen Multilevel-Stromrichters (21) elektrisch verbunden ist.

11. Modulare Antriebseinheit (20) nach Anspruch 10, wobei eine Wechselspannungsseite des modularen Multilevel-Stromrichters (21) mit einer Energiequelle (5), insbesondere mit einem Energieversorgungsnetz (6) oder mit einer elektrischen Maschine (7), verbunden ist.

12. Modulare Antriebseinheit (20) nach einem der Ansprüche 10 oder 11, wobei die Steuereinrichtung (10) eingerichtet ist, die in Wärme umzuwandelnde Leistung in Abhängigkeit von der Spannung des Kondensators der Submodule des modularen Multilevel-Stromrichters (21) zu ermitteln.

FIG 1

## FIG 2

## FIG 3

FIG 4

$$U_{C,sub}$$

$$U_{sub}$$

FIG 5

FIG 6

EP 4 329 180 A1

FIG 7

FIG 8

## FIG 9

FIG 10

FIG 11

| | Europäisches Patentamt European Patent Office Office européen des brevets | **EUROPÄISCHER RECHERCHENBERICHT** | **Nummer der Anmeldung** **EP 22 19 1461** |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | BIRKEL ANDRE ET AL: "Analysis and semiconductor based comparison of energy diverting converter topologies for HVDC transmission systems", 2015 17TH EUROPEAN CONFERENCE ON POWER ELECTRONICS AND APPLICATIONS (EPE'15 ECCE-EUROPE), JOINTLY OWNED BY EPE ASSOCIATION AND IEEE PELS, 8. September 2015 (2015-09-08), Seiten 1-10, XP032800044, DOI: 10.1109/EPE.2015.7309087 [gefunden am 2015-10-27] * Abschnitt Conclusions: "The chopper based topologies work with a square wave voltage modulation over the braking resistors", Abschnitt "Modulation of the MMC Braker dependent on the dc voltage level" Table II: "square-wave". Gleichungen 1-9; Abbildungen 1-5 * ----- | 1-12 | INV. H02M7/483 H02M1/32 H02P3/22 H02H9/04 |
| X | CAO SHUAI ET AL: "Energy dissipation of MMC-HVDC based onshore wind power integration system with FB-DBS and DCCB", IET RENEWABLE POWER GENERATION, THE INSTITUTION OF ENGINEERING AND TECHNOLOGY, MICHAEL FARADAY HOUSE, SIX HILLS WAY, STEVENAGE, HERTS. SG1 2AY, UK, Bd. 14, Nr. 2, 3. Februar 2020 (2020-02-03), Seiten 222-230, XP006088824, ISSN: 1752-1416, DOI: 10.1049/IET-RPG.2019.0491 * Abschnitt 3.2 Operation principle of cascaded FBSM; Gleichung 1; Abbildungen 1-9 * ----- -/-- | 1-12 | **RECHERCHIERTE SACHGEBIETE (IPC)** H02M H02H H02P |

Der vorliegende Recherchenbericht wurde für alle Patentansprüche erstellt

| Recherchenort | Abschlußdatum der Recherche | Prüfer |
|---|---|---|
| Den Haag | 30. Januar 2023 | Kanelis, Konstantin |

EPO FORM 1503 03.82 (P04C03)

# EP 4 329 180 A1

Europäisches Patentamt
European Patent Office
Office européen des brevets

## EUROPÄISCHER RECHERCHENBERICHT

Nummer der Anmeldung

EP 22 19 1461

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LI ZHENGXUAN ET AL: "Energy Diverting Converter Topology Using Unidirectional Current H-Bridge Submodules for VSC-HVDC Transmission System", IEEE TRANSACTIONS ON POWER ELECTRONICS, INSTITUTE OF ELECTRICAL AND ELECTRONICS ENGINEERS, USA, Bd. 37, Nr. 5, 9. Dezember 2021 (2021-12-09), Seiten 5299-5308, XP011898442, ISSN: 0885-8993, DOI: 10.1109/TPEL.2021.3133498 [gefunden am 2022-01-19] * Abschnitt V. SIMULATION RESULTS; Gleichungen 1-6; Abbildungen 3-5,12 * ----- | 1-12 | |
| X | XU BIN ET AL: "The State of Art of Energy Consumption Devices for Offshore Wind Power System", 2021 INTERNATIONAL CONFERENCE ON POWER SYSTEM TECHNOLOGY (POWERCON), IEEE, 8. Dezember 2021 (2021-12-08), Seiten 1510-1514, XP034080434, DOI: 10.1109/POWERCON53785.2021.9697886 [gefunden am 2022-01-28] | 1,2,7-12 | |
| A | * Abschnitt IV. COMPARISONS AND SIMULATIONS; Abbildungen 3,5,7 * ----- | 3-6 | |
| X | EP 2 834 896 B1 (GEN ELECTRIC TECHNOLOGY GMBH [CH]) 25. Mai 2016 (2016-05-25) | 1,2,7-12 | |
| A | * Absätze [0096], [0097]; Abbildungen 7,9b,9c * ----- | 3-6 | |
| X | US 2017/257022 A1 (BRYANT ANGUS [DE]) 7. September 2017 (2017-09-07) | 1,2,7-12 | |
| A | * Absatz [0056]; Abbildungen 6,7 * ----- | 3-6 | |
| | -/-- | | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 30. Januar 2023 | Kanelis, Konstantin |

EPO FORM 1503 03.82 (P04C03)

Europäisches Patentamt
European Patent Office
Office européen des brevets

# EUROPÄISCHER RECHERCHENBERICHT

**Nummer der Anmeldung**

EP 22 19 1461

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2017/021169 A1 (ABB SCHWEIZ AG [CH]) 9. Februar 2017 (2017-02-09) | 1,2,7-12 | |
| A | * Seite 8, Zeilen 14-16; Abbildungen 1,6-9 * | 3-6 | |
| | ----- | | |
| A | CAO SHUAI ET AL: "AC and DC fault ride through hybrid MMC integrating wind power", THE JOURNAL OF ENGINEERING, THE INSTITUTION OF ENGINEERING AND TECHNOLOGY, MICHAEL FARADAY HOUSE, SIX HILLS WAY, STEVENAGE, HERTS. SG1 2AY, UK, Bd. 2017, Nr. 13, 1. Januar 2017 (2017-01-01), Seiten 828-833, XP006065959, DOI: 10.1049/JOE.2017.0446 * Abschnitt 4.2 AC fault ride-through; Abschnitt 5.3 AC single-phase grounding fault ride through; Abbildungen 2-44, 7, 9, 10 * | 1-12 | |
| | ----- | | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 30. Januar 2023 | Kanelis, Konstantin |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 19 1461

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-01-2023

| Im Recherchenbericht angeführtes Patentdokument | Datum der Veröffentlichung | Mitglied(er) der Patentfamilie | Datum der Veröffentlichung |
|---|---|---|---|
| EP 2834896 B1 | 25-05-2016 | KEINE | |
| US 2017257022 A1 | 07-09-2017 | BR 112017008991 A2 | 26-06-2018 |
| | | CN 107078629 A | 18-08-2017 |
| | | EP 3221954 A1 | 27-09-2017 |
| | | GB 2534348 A | 27-07-2016 |
| | | JP 2017536078 A | 30-11-2017 |
| | | KR 20170086626 A | 26-07-2017 |
| | | MX 368092 B | 19-09-2019 |
| | | RU 2017121581 A | 24-12-2018 |
| | | SG 11201703282P A | 29-06-2017 |
| | | US 2017257022 A1 | 07-09-2017 |
| | | WO 2016079039 A1 | 26-05-2016 |
| WO 2017021169 A1 | 09-02-2017 | EP 3329585 A1 | 06-06-2018 |
| | | WO 2017021169 A1 | 09-02-2017 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10103031 A1

- WO 2007023061 A2